# EUROPÄISCHE PATENTSCHRIFT

(11) **EP 2 366 197 B1**
(45) Veröffentlichungstag und Bekanntmachung des Hinweises auf die Patenterteilung: **01.06.2016**
(21) Anmeldenummer: 09801908.6
(22) Anmeldetag: 14.12.2009
(51) Int. Cl.: H01L 33/00, B44F 1/06, B44F 1/10, A44C 15/00, A44C 17/00

(54) **TRANSPARENTER KÖRPER MIT UNSICHTBARER LED-LICHTQUELLE**
TRANSPARENT BODY WITH INVISIBLE LED LIGHT SOURCE
CORPS TRANSPARENT AVEC SOURCE D'ILLUMINATION A BASE DE DEL INVISIBLE

(30) Priorität: 16.12.2008 AT 19562008
(43) Veröffentlichungstag der Anmeldung: 21.09.2011
(73) Patentinhaber: D. Swarovski KG, 6112 Wattens (AT)
(72) Erfinder: TEISSL, Christian, A-6020 Innsbruck (AT)
(74) Vertreter: Torggler & Hofinger Patentanwälte
(86) Internationale Anmeldenummer: PCT/AT2009/000483
(87) Internationale Veröffentlichungsnummer: WO 2010/075599

(56) Entgegenhaltungen:
- EP-A1- 1 715 521
- EP-A2- 0 363 132
- WO-A1-2007/045786
- DE-A1-102004 039 897
- US-A- 4 942 744
- US-A1- 2004 196 650
- US-A1- 2009 108 267

## Beschreibung

Die vorliegende Erfindung betrifft einen Körper aus transparentem Material.

Ein solcher Körper geht beispielsweise aus der WO 2006/130887 A2 hervor. Diese Schrift beschäftigt sich mit der Aufgabenstellung, einen Körper aus transparentem Material mit einer Markierung zu versehen, welche das optische Erscheinungsbild des Körpers nur unter bestimmten Bedingungen beeinflusst. Vorgeschlagen wird hierfür, den Körper mit einer Vielzahl von Mikrolöchern zu versehen, welche mit in einer Matrix eingebetteten licht-emittierenden Nanopartikel gefüllt sind. So wird erreicht, dass die Markierung nur dann sichtbar wird, wenn der Körper mit elektromagnetischer Strahlung beleuchtet wird, deren Wellenlänge vorzugsweise im nicht sichtbaren Spektralbereich liegt. Die elektromagnetische Strahlung wird durch eine außerhalb des Körpers angeordnete Vorrichtung, beispielsweise einen UV-A-Strahler, bereitgestellt.

Diese Lösung ist im Hinblick auf das in der WO 2006/130887 A2 beschriebene Hauptanwendungsgebiet (*Markierungen* als Fälschungsschutz) durchaus zufriedenstellend. Wie bereits in der WO 2006/130887 A2 angedacht, können derartige Markierungen jedoch auch einen künstlerischen Zweck haben, in dem sie beispielsweise in Form von ansprechenden Grafiken ausgebildet sind.

Ganz allgemein kann es wünschenswert sein, bestimmte Eigenschaften eines Körpers aus transparentem Material durch einen geeigneten Lichteinfall hervorzuheben. Um vom Umgebungslicht unabhängig zu sein, ist es bereits bekanntgeworden, in Hohlräumen derartiger Körper lichterzeugende Vorrichtungen anzuordnen, die jedoch ihrerseits das optische Erscheinungsbild des Körpers stören. Bisherige Maßnahmen, derartige lichterzeugende Vorrichtungen verdeckt am Körper anzubringen, sind je nach Körper entweder nur bedingt erfolgreich oder mit beträchtlichem konstruktivem Aufwand verbunden.

US 4 942 744 A offenbart einen "self shining artificial jewelry device", bestehend aus einem Körper, welcher wenigstens abschnittweise facettiert ist, mit einer im Körper angeordneten lichterzeugenden LED-Vorrichtung, wobei im Körper zur Aufnahme der LED-Vorrichtung ein Loch ausgebildet ist.

In den letzten Jahren sind sogenannte TOLEDs (das sind transparente organische LEDs) bekanntgeworden. Diese weisen eine ganze Reihe von Nachteilen auf. So sind derartige TOLEDs aufgrund ihrer geringen Leuchtdichte nur flächig anwendbar. Ihre, Lebensdauer ist zum heutigen Zeitpunkt relativ gering. Sie weisen eine schlechte Farbqualität auf und sie sind relativ empfindlich auf Feuchtigkeit und Sauerstoff.

Aufgabe der Erfindung ist es, einen Körper aus transparentem Material bereitzustellen, bei dem ein gewünschtes optisches Erscheinungsbild unabhängig von einer Umgebungsbeleuchtung erzielbar ist.

Diese Aufgabe wird durch einen Körper mit den Merkmalen des Anspruchs 1 gelöst. Durch die Verwendung von anorganischen Halbleiterchips können lichterzeugende Vorrichtungen realisiert werden, die unsichtbar im oder am Körper angeordnet sind und eine oder mehrere quasi-punktförmige Quellen aufweisen.

In der gesamten Offenbarung wird unter "Licht" elektromagnetische Strahlung verstanden, deren Wellenlänge im sichtbaren Spektralbereich liegt.

Unter "unsichtbar" wird in der vorliegenden Offenbarung ein Gegenstand verstanden, welcher zumindest bei Beleuchtung mit diffusem, unpolarisiertem, weißem Licht - vorzugsweise aber auch bei Beleuchtung mit direktem, unpolarisiertem, weißem Licht, bei weißem Hintergrund, vorzugsweise aber auch bei schwarzem Hintergrund - mit einer Beleuchtungsstärke von 500 Lux (gemessen am Ort des Gegenstandes) - vorzugsweise auch bei etwa 1000 Lux - bei einem, der Funktion angemessenen Betrachtungsabstands (zum Beispiel 0,2 m bei dekorativen Steft-Gegenständen, 1 m bei hängenden Beleuchtungs-Gegenständen) -für einen normalsichtigen Betrachter unabhängig von der Betrachtungsrichtung ohne technische Hilfsmittel ("unbewaffnetens Auge") nicht erkennbar ist.

Der anorganische Halbleiterchip (der stets wenigstens eine Diode aufweist, die zur Emission von elektromagnetischer Strahlung, zum Beispiel Licht geeignet ist) kann selbst bereits Licht emittieren. Alternativ kann jedoch auch vorgesehen sein, dass der Halbleiterchip zur Emission von elektromagnetischer Strahlung außerhalb des sichtbaren Spektralbereichs ausgebildet ist. In diesem Fall wird es in den meisten Fällen erforderlich sein, dass die Vorrichtung einen Wellenlängenkonverter zur wenigstens teilweisen Konvertierung wenigstens eines Teiles der vom Halbleiterchip emittierten Strahlung in Licht aufweist. Der Wellenlängenkonverter kann beispielsweise von einer Vielzahl von im Nanometerbereich großen lichtemittierenden Partikeln gebildet werden, wobei die Partikelgröße vorzugsweise kleiner als ca. 1/20 der Wellenlänge von Licht sein soll, um die Streuung von Licht im sichtbaren Spektralbereich zu vermeiden.

Um die Effizienz der Vorrichtung zu vergrößern, kann vorgesehen sein, dass sie einen wenigstens teiltransparenten Spiegel aufweist, durch den zumindest ein Teil der vom Halbleiterchip emittierten Strahlung in den Körper hineinreflektierbar ist. Dieser Spiegel kann beispielsweise in Form eines UV-Reflektors ausgebildet sein, welcher zwar UV-A Strahlung reflektiert, Licht jedoch ungehindert passieren lässt. Solche Spiegel können beispielsweise mittels Mehrschichtsystemen und/oder photonischen Kristallen realisiert werden.

Vorzugsweise ist vorgesehen, dass im Körper zur wenigstens teilweisen Aufnahme des Halbleiterchips ein Mikroloch ausgebildet ist. Vorteilhaft ist dabei, wenn der Halbleiterchip zumindest im Wesentlichen bündig mit der das Mikroloch umgebenden Oberfläche abschließt. Das Mikroloch kann einen Durchmesser in der Größenordnung von wenigen 100 µm bis einige 10 µm aufweisen. Solche Mikrolöcher unterschiedlicher Querschnitte und hoher Qualität können beispielsweise mittels Laser berührungslos und effizient realisiert werden. Zur einfachen Sicherstellung der Bündigkeit des Halbleiterchips mit der Oberfläche des transparenten Materials, sowie - falls erforderlich - eines entsprechenden Wellenlängenkonvertres bestimmter Dicke, können geeignete Abstandhalter im Mikroloch platziert werden. Dies kann zum Beispiel bei der Herstellung der Mikrolöcher geschehen.

Grundsätzlich kann das Mikroloch entweder im Körper unterhalb der Oberfläche angeordnet sein oder sich an einer Oberfläche des Körpers befinden.

Vorteilhafterweise erfolgt die Energieversorgung der Vorrichtung über unsichtbar im oder am Körper angeordnete elektrische Zuleitungen und Kontakte. Zu diesem Zweck kann beispielsweise eine entsprechende leitfähige Schicht, wie etwa aus transparenten, leitfähigen Oxiden (engl. Transparent Contacting Oxids oder TCO) in geeigneter Weise auf die Oberfläche des Körpers aufgebracht werden. Ein Beispiel für ein geeignetes TCO ist ITO (indiumzinnoxid). Solche transparenten leitfähigen ITO-Beschichtungen können beispielsweise auf die Oberfläche des Körpers aufgesputtert oder aufgedampft werden. Andere Möglichkeiten der Aufbringung von elektrischen Kontaktierungsmitteln, wie zum Beispiel transparente leitfähige Polymere, können ebenfalls zum Einsatz kommen (beispielsweise durch aufdrucken mittels Siebdruck oder Tintenstrahldrucker).

Besonders bevorzugt ist vorgesehen, dass die Vorrichtung zur Abgabe von weißem Licht ausgebildet ist. Dies kann entweder derart erfolgen, dass der Halbleiterchip nur zur Emission von elektromagnetischer Strahlung einer einzigen Wellenlänge ausgebildet ist und Wellenlängenkonverter bereitgestellt werden, welche die vom Halbleiterchip emittierte Strahlung in jene Lichtkomponenten transformieren, welche benötigt werden, um insgesamt weißes Licht entsprechender Qualität (das heißt zum Beispiel Licht mit einer geforderten Spektrallinienverteilung, Color Rendering Index und Farbtemperatur) zur Verfügung zu haben. Beispielsweise kann auch vorgesehen sein, in einem einzigen Halbleiterchip Mittel zur Erzeugung von Licht mit zwei verschiedenen Wellenlängen bereitzustellen (zum Beispiel blau und grün) und die fehlende Wellenlänge (zum Beispiel rot) über einen Wellenlängenkonverter bereitzustellen. Vorstellbar ist auch die Erzeugung von Licht mit drei und mehr unterschiedlichen Wellenlängen in einem monolithischen Ansatz, das heißt in einem einzigen Halbleiterchip.

Besonders bevorzugt ist es, wenn die Vorrichtung weißes Licht abgibt, welches sehr viele Spektrallinien aufweist und nach Möglichkeit dem Sonnenspektrum vergleichbar ist, da dann besonders bei zumindest abschnittsweise facettiert ausgebildeten Körpern bei der Betrachtung und Drehung des Körpers viele verschiedene Farben sichtbar werden.

Als transparentes Material des Körpers kommt beispielsweise farbloses Glas in Frage. Natürlich kann der Körper auch aus einem farbigen Glas, Edelstein, Halbedelstein, Keramik, Kunststoff oder einem kristallinen transparenten Materialien bestehen. Das transparente Material kann natürlich aus unterschiedlichen Gründen an manchen Stellen nicht-transparent abgeschlossen sein, zum Beispiel durch Verspiegelungen, Farbeffektschichten, Verklebungen etc.

Besonders dann, wenn der Körper eine dekorative Funktion aufweisen soll, wird vorgesehen, den Körper wenigstens abschnittsweise facettiert auszubilden.

Die unsichtbare Anordnung der Vorrichtung im Körper kann grundsätzlich durch zwei verschiedene Methoden erfolgen, die sich allerdings nicht gegenseitig ausschließen, sondern durchaus auch kombiniert werden können.

So kann beispielsweise vorgesehen sein, die Vorrichtung kleiner als 100 µm, bevorzugt kleiner als 50 µm auszubilden. Diese würde bei einem angenommenen Betrachterabstand von etwa 0,2 m einer Winkelgröße von etwa 50 Bogensekunden und somit der Punktschärfe des menschlichen Auges entsprechen (jenem Abstand zwischen zwei Bildpunkten, welche das Auge noch als getrennt wahrnehmen kann). In diesem Fall ist es also nicht unbedingt erforderlich, die Vorrichtung selbst zur Gänze transparent auszubilden, jedoch ist zu berücksichtigen, däss sich die resultierende Sichtbarkeit aus einer gewichteten Summe der Sichtbarkeit der einzelnen Elemente der Vorrichtung ergibt. Das heißt, der "Grauwert" des jeweiligen Elementes teilt sich entsprechend seines Betrages und seiner beanspruchten Fläche auf die Fläche des minimal auflösbaren Punktes auf.

Zusätzlich oder alternativ wird vorgesehen, dass zumindest der Halbleiterchip transparent ausgebildet ist. In diesem Fall kann der Halbleiterchip durchaus auch größer als 50 µm oder 100 µm (zum Beispiel einige 100 µm) sein. Zur Erzielung einer erhöhten Unsichtbarkeit der Vorrichtung kann diese in ein optisches Immersionsmedium eingebettet werden, dessen Brechungszahl auf jene des transparenten Materials des Körpers abgestimmt ist.

Dabei ist es nicht unbedingt erforderlich aller Komponenten der Vorrichtung transparent auszubilden, da ja der Halbleiterchip selbst die größte Dimensionierung aufweist und es durchaus sein kann, dass beispielsweise Stromkontakte oder Ähnliches ohnehin so klein sind, dass sie für das menschliche Auge nicht erkennbar sind. Es liegt aber natürlich durchaus im Rahmen der Erfindung, alle Komponenten der Vorrichtung transparent auszubilden.

Zum Ableiten der in der Vorrichtung erzeugten Wärme können - falls erforderlich - entsprechende Wärmeableitmittel bereitgestellt werden. Zum Beispiel kann eine Kohlenstoff-Nano-Röhrchen enthaltende transparente Paste oder auch eine mit mikro-oder nanokristallinem Diamant versehene transparente Paste vorgesehen sein, durch welche die Wärme in das Umgebungsmaterial der Vorrichtung in den transparenten Körper geführt wird.

Der transparente Flip-Chip Ansatz ist eine weitere bevorzugte Ausführung. Flip Chip Packaging ist eine bekannte Alternative zum bisher diskutierten regulären Packaging (Epi-side-packaging, nachfolgend auch als "Top-Kontakt-Ansatz" bezeichnet). Diese Alternative wird im Allgemeinen bei Hochleistungs-Anwendungen bevorzugt, bei welchen die Metall-Anschlüsse eine hoch-effiziente Extrahierung des erzeugten Lichts behindern würden.

Den Flip-Chip Ansatz transparent zu gestalten ist ein weiterer Gegenstand der vorliegenden Erfindung. Dabei wird in ein transparentes Material des Körpers bevorzugt ein Mikroloch der Form eingebracht, bei welcher der Übergang zum Grund des Mikrolochs nicht abrupt in Form einer vertikalen Klippe, sondern zumindest auf einer Seite abgeflacht erfolgt. Die Dimensionen des Mikrolochs sind dabei bevorzugt in der Größenordnung des Halbleiterchips und können an einer oder mehreren Flanken einen flachen Übergang besitzen. Dies hat den Vorteil, dass bei herkömmlichen, meist gerichteten Beschichtungsmethoden, eine vergleichsweise homogene, transparente, leitfähige Schicht als elektrischer Kontakt aufgetragen werden kann. Diese kann z.B. eine TCO-Schicht (z.B. ITO) sein, welche mittels Aufdampfen oder Sputtem aufgebracht wird. Eine weitere interessante Möglichkeit stellen transparente leitfähige Tinten dar (vgl. z.B. Clevios ®, nanoskalares ITO mit anschließendem Sinter-Prozess; Tinten mit Carbon Nano Tubes; etc.). Eine zusätzliche Option sind z.B. gedruckte, hoch-feine Linien (z.B. aus Silber-Nanopartikel), welche aufgrund ihrer geringen Dimensionen (unter 50 µm) kaum sichtbar sind. Optional können auf die Schicht leitfähige Pads aufgebracht werden, welche, sofern die Dimensionen entsprechend klein sind (typischerweise unter 50 µm), auch metallisch bzw. nicht transparent ausgeführt sein können. Solche Pads können durch eine Vielzahl von bestehenden Methoden aufgebracht werden, wie z.B. Sputtern, Electroplating, oder mittels Lithographischer- oder bestimmter Druckverfahren (z.B. Tintenstrahl-Druck).

Der transparente Halbleiterchip wird aus Stabilitätsgründen bevorzugt aus dem transparenten Substrat (z.B. Saphir) und der anorganischen LED (engl. ILED, z.B. GaN) gebildet, kann jedoch auch nur aus dem anorganischen Halbleiter bestehen, was die Einbautiefe erheblich reduziert (von typisch 50-150 µm auf etwa 10 µm und darunter). Der Chip kann dabei mit konventionellen Methoden (z.B. mittels eines Stempels mit Ansaugvorrichtung) schnell und präzise positioniert werden.

Die halbleiterseitige Stromverteilungsschicht ist ebenfalls transparent ausgeführt (z.B. mittels ITO-Beschichtung). Die Chip-seitigen P- und N-Kontakte können wahlweise zusätzlich noch aus nicht-transparentem Material (z.B. Gold) ausgeführt werden, sofern durch kleine Abmessungen die Unsichtbarkeit gewährleistet bleibt.

Die elektrisch leitfähige, mechanisch stabile und transparente Verbindung zwischen Halbleiterchip und der am Körper angeordneten transparenten, leitfähigen Schicht kann auf unterschiedliche Art realisiert werden. Bevorzugte Ausführungen sind unter anderem die Kaltverschweißung von metallischen Mikro-Kontakten (z.B. Mikro- Gold Stud Bumps), leitfähige Verklebungen (z.B. druckbare, UV-aushärtende Kleber mit Silber-Nanopartikeln), oder transparente leitfähige Brücken mittels druckbaren ITO.

Eine gegebenenfalls notwendige Wellenlängenumwandlung kann z.B. mittels Unterfüllung einer entsprechenden, Index-angepassten Matrix mit nanoskalaren Phosphor transparent realisiert werden. Eine andere Möglichkeit wäre die Wellenlängen-Konversion mittels eines dünnen, mit nanoskalaren Phosphor "dotierten" Plättchen bzw. einer Folie.

Weitere Vorteile und Einzelheiten der Erfindung ergeben sich anhand der Figuren sowie der dazugehörigen Figurenbeschreibung.

Die Fig. 1 zeigt die unsichtbare Einbettung einer lichterzeugenden Vorrichtung 2, welche einen anorganischen Halbleiterchip 4 aufweist, in ein Mikroloch 9 eines transparenten Körpers 1. *Der* transparente Körper 1 als Ganzes ist in der Fig. 2 erkennbar.

Die Fig. 3 und 4 zeigen Ausführungsbeispiele zum Top-Kontakt-Ansatz mit bzw. ohne Verwendung eines Mikrolochs, wobei ohne Verwendung eines Mikrolochs nicht erfindungsgemäß ist.

Fig. 5 zeigt ein Ausführungsbeispiel zum Flip-Chip-Packaging mit Mikroloch, die Fig. 6 zeigt ein entsprechendes nicht erfindungsgemäßes Ausführungsbeispiel ohne Verwendung eines Mikrolochs.

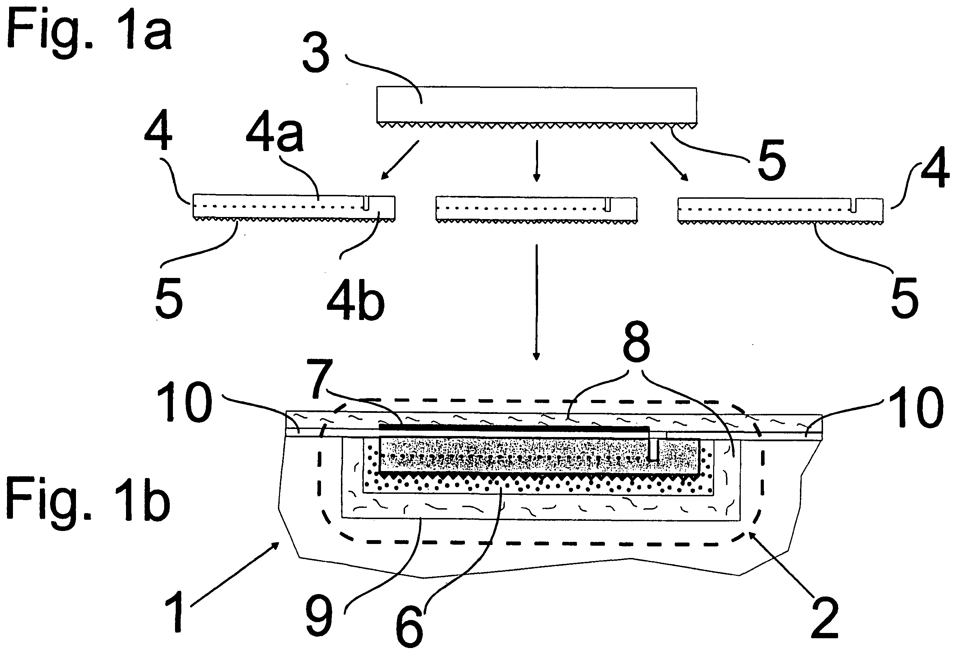

In einem ersten Schritt kann von einem Wafer 3 die Substratschicht entfernt werden, welche dazu gedient hat, ein möglichst gleichmäßiges Wachstum der Kristallschicht zu gestatten. Dies kann zum einen erforderlich sein, wenn das Substrat nicht lichtdurchlässig ist. Es kann jedoch auch von Vorteil sein, um die Tiefe der Vorrichtung erheblich zu reduzieren. Die mechanische Stabilität wird nach erfolgtem Einbau vom transparenten Körper 1 selbst gewährleistet - der Körper 1 selbst bildet dann also das Substrat. Anschließend wird der Wafer 3 in einzelne Halbleiterchips 4 zerlegt (Fig. 1 a). Erkennbar ist eine optionale Oberflächenstrukturierung 5 an der Unterseite der Halbleiterchips 4 zur Erhöhung der Auskoppeleffizienz der in der/den aktiven Schicht/Schichten der Strahlung emittierenden Diode des Halbleiterchips 4 erzeugten Strahlung. Eine andere Möglichkeit der Erhöhung der Auskoppeleffizienz stellen zum Beispiel photonische Kristalle dar.

Anschließend kann der Halbleiterchip 4 mit einem als Wellenlängenkonverter 6 fungierendem Phosphor umgeben und an der einen Seite mit einem entsprechenden Reflektor als Spiegel 7 versehen werden. In diesem Fall ist der anorganische Halbleiterchip 4 also bevorzugt als UV-A- oder blaue LED ausgebildet. Diese Anordnung kann mit einer transparenten, wärmeleitenden Schicht, zum Beispiel einer Silkon-/Kohlenstoff-Nano-Röhrchen Zusammensetzung als Wärmeableiter 8 ummantelt werden, welche die im Betrieb entstehende Wärme in den Körper 1 abführt.

Im gezeigten Ausführungsbeispiel ist die obere Schicht 4a des Halbleiterchips 4, der bevorzugt aus einem III-V Nitrid Halbleiter-Material System, wie zum Beispiel GaN besteht, p-dotiert und die untere Schicht 4b ist n-dotiert.

In Fig. 1b ist die Vorrichtung 2 in einem Mikroloch 9 eines Körpers 1 aus transparentem Material im Wesentlichen bündig mit der Oberfläche des Körpers 1 eingesetzt. Erkennbar ist die Kontaktierung der Vorrichtung 2 über eine transparente leitfähige Schicht, hier eine TCO (ITO) Schicht, welche zum Beispiel aufgedampft oder aufgesputtert wurde und als elektrischer Kontakt 10 fungiert.

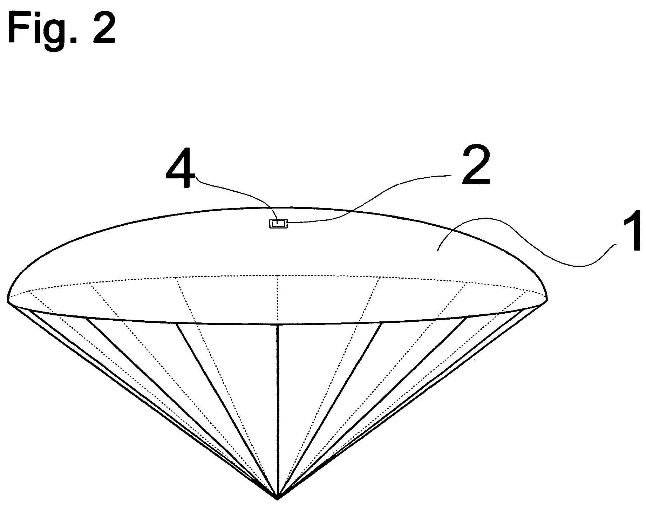

Die Fig. 2 zeigt noch eine Gesamtansicht des Körpers 1. Die Darstellung des Mikrolochs 9 und der Vorrichtung 2 ist natürlich nicht maßstabsgerecht.

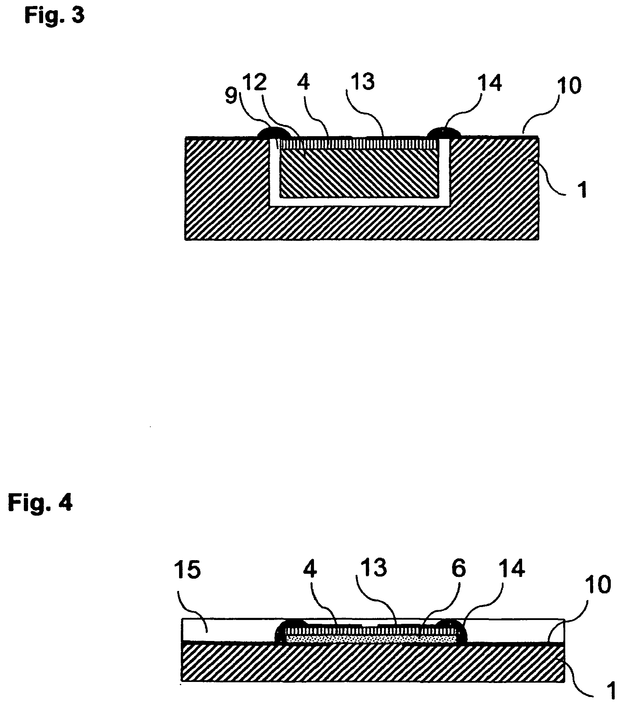

### Zur Fig. 3:

Vereinfachte, schematische Darstellung einer bevorzugten Ausführung der Top-Kontakt Montage: Körper 1 aus transparentem Material; Mikroloch 9; Transparente leitfähige Schicht 10; Substrat 12 (optional); Anorganischer Halbleiterchip 4; Transparente P- bzw. N-Stromverteilungsschicht 13 (+ P- bzw. N-Kontakt, optional) Transparente, leitfähige Verbindung 14 (z.B. nanoskalares ITO mittels Tintenstrahldrucker; aufgrund der Mikrostrukturierung nicht wahrnehmbare metallische Verbindungen, wie z.B. nanoskalare Silberpartikel in einer Matrix, mittels Tintenstrahldrucker aufbringbar) oder auf Grund der Mikrostrukturierung nicht wahrnehmbare metallische Verbindung (z.B. nanoskalare Silberpartikel in einer Matrix, mittels Tintenstrahldrucker aufbringbar); Optionale Isolationsschichten (z.B. SiO2), Wärmeableitungsschichten, Wellenlängen-selektive Spiegel u.a. sind nicht eingezeichnet; der noch verbleibende freie Raum des Mikrolochs 9 wird in einer bevorzugten Ausführung mit einer an das transparente Material Index-angepassten Phosphor-dotierten Matrix 6 ausgefüllt.

### Zur Fig. 4:

Vereinfachte, schematische Darstellung einer weiteren bevorzugten Ausführung der Top-Kontakt Montage: Körper 1 aus transparentem Material; Transparente leitfähige Schicht 10; Anorganischer Halbleiterchip 4 (kein Substrat - Dicke < 20 µm); Transparente P- bzw. N-Stromverteilungsschicht 13 (+ P- bzw. N-Kontakt, optional; Transparente, leitfähige Verbindung 14 (z.B. nanoskalares ITO mittels Tintenstrahldrucker); Optional: Wellenlängenkonverter 6 (z.B. druckbare, dünne UVaushärbare Matrix mit eingebettetem nano-skalaren Phosphor); Optional: Schutzschicht 15 (z.B. widerstandsfähige, druckbare, transparente Sol-Gel-Beschichtung); Optionale Isolationsschichten (z.B. SiO2), Wärmeableitungsschichten, Wellenlängen-selektive Spiegel u.a. sind nicht eingezeichnet;

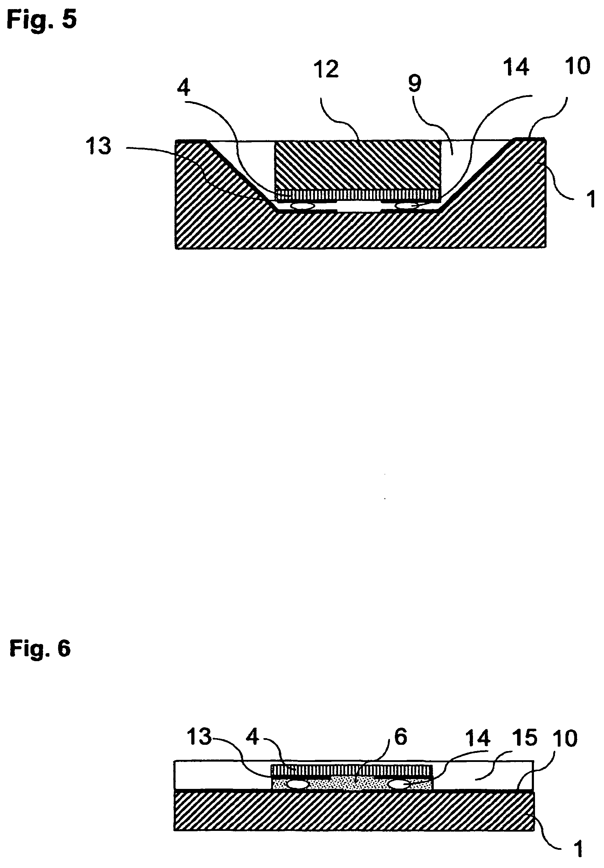

### Zur Fig. 5:

Vereinfachte, schematische Darstellung der Flip Chip Montage: Körper 1 aus transparentem Material; Transparente leitfähige Schicht 10; Substrat 12 (optional); Anorganischer Halbleiterchip 4; Transparente P- bzw. N-Stromverteilungsschicht 13 (+ P- bzw. N-Kontakt, optional); Leitfähige Verbindung 14; Optionale Isolationsschichten (z.B. SiO2), Wärmeableitungsschichten, Wellenlängen-selektive Spiegel u.a. sind nicht eingezeichnet; der noch verbleibende freie Raum des Mikrolochs 9 wird in einer bevorzugten Ausführung mit einer an das transparente Material Index-angepassten Phosphor-dotierten Matrix 6 ausgefüllt.

### Zur Fig. 6:

Vereinfachte, schematische Darstellung der Flip Chip Montage: Körper 1 aus transparentem Material; Mikroloch 9; Transparente leitfähige Schicht 10; Anorganischer Halbleiterchip 4; Transparente P- bzw. N-Stromverteilungsschicht 13 (+ P- bzw. N-Kontakt, optional); Leitfähige Verbindung 14; Optional: Wellenlängenkonverter (z.B. druckbare, dünne UV-aushärtbare Matrix mit eingebettetem nano-skalaren Phosphor); Optional: Schutzschicht 15 (z.B. widerstandsfähige, druckbare, transparente Sol-Gel-Beschichtung); Optionale Isolationsschichten (z.B. SiO2), Wärmeableitungsschichten, Wellenlängen-selektive Spiegel u.a. sind nicht eingezeichnet; Optionale Isolationsschichten (z.B. SiO2), Wärmeableitungsschichten, Wellenlängen-selektive Spiegel und andere sind nicht eingezeichnet;

## Patentansprüche

1. Körper aus transparanten Glas, welcher wenigstens abschnittweise facettiert ist, mit wenigstens einer unsichtbar im oder am Körper (1) angeordneten lichterzeugenden Vorrichtung (2), die zumindest einen anorganischen Halbleiterchip (4) aufweist, wobei im Körper (1) zur wenigstens teilweisen Aufnahme des Halbleiterchips (4) ein Mikroloch (9) ausgebildet ist und wobei zumindest der Halbleiterchip (4) transparent ausgebildet ist.

2. Körper nach Anspruch 1, **dadurch gekennzeichnet, dass** der Halbleiterchip (4) zur Emission von elektromagnetischer Strahlung im sichtbaren Spektralbereich ausgebildet ist.

3. Körper nach Anspruch 1, **dadurch gekennzeichnet, dass** der Halbleiterchip (4) zur Emission von elektromagnetischer Strahlung außerhalb des sichtbaren Spektralbereichs ausgebildet ist.

4. Körper nach Anspruch 2 oder 3, **dadurch gekennzeichnet, dass** die Vorrichtung (2) einen Wellenlängenkonverter (6) zur wenigstens teilweisen Konvertierung wenigstens eines Teiles der vom Halbleiterchip (4) emittierten Strahlung in Licht aufweist.

5. Körper nach einem der Ansprüche 1 bis 4, **dadurch gekennzeichnet, dass** die Vorrichtung (2) einen wenigstens teiltransparenten Spiegel (7) aufweist, durch den zumindest ein Teil der vom Halbleiterchip (4) emittierten Strahlung in den Körper (1) hinein reflektierbar ist.

6. Körper nach einem der Ansprüche 1 bis 5, **dadurch gekennzeichnet, dass** das Mikroloch (9) an einer Oberfläche des Körpers (1) angeordnet ist.

7. Körper nach einem der Ansprüche 1 bis 6, **dadurch gekennzeichnet, dass** die Energieversorgung der Vorrichtung (2) über unsichtbar im oder am Körper (1) angeordnete elektrische Kontakte (10) erfolgt.

8. Körper nach einem der Ansprüche 1 bis 7, **dadurch gekennzeichnet, dass** die Vorrichtung (2) zur Abgabe von weißem Licht ausgebildet ist.

9. Körper nach einem der Ansprüche 1 bis 8, **dadurch gekennzeichnet, dass** die Vorrichtung (2) kleiner als 100 µm ist.

10. Körper nach einem der Ansprüche 1 bis 9, **dadurch gekennzeichnet, dass** alle Komponenten der Vorrichtung (2) transparent ausgebildet sind.

11. Körper nach Anspruch 1 oder 10, **dadurch gekennzeichnet, dass** die Vorrichtung (2) in ein optisches Immersionsmedium eingebettet ist, dessen Brechungszahl auf jene des transparenten Materials des Körpers (1) abgestimmt ist.

## Claims

1. A body of transparent glass which is at least portion-wise faceted, comprising at least one light-generating device (2) which is arranged invisibly in or on the body (1) and which has at least one inorganic semiconductor chip (4), wherein a microhole (9) is provided in the body (1) for at least partially receiving the semiconductor chip (4) and wherein at least the semiconductor chip (4) is transparent.

2. A body according to claim 1 **characterised in that** the semiconductor chip (4) is adapted to emit electromagnetic radiation in the visible spectral range.

3. A body according to claim 1 **characterised in that** the semiconductor chip (4) is adapted to emit electromagnetic radiation outside the visible spectral range.

4. A body according to claim 2 or claim 3 **characterised in that** the device (2) has a wavelength converter (6) for at least partially converting at least a part of the radiation emitted by the semiconductor chip (4) into light.

5. A body according to one of claims 1 to 4 **characterised in that** the device (2) has an at least partially transparent mirror (7) by which at least a part of the radiation emitted by the semiconductor chip (4) can be reflected into the body (1).

6. A body according to one of claims 1 to 5 **characterised in that** the microhole (9) is arranged at a surface of the body (1).

7. A body according to one of claims 1 to 6 **characterised in that** the energy supply for the device (2) is effected by way of electrical contacts (10) arranged invisibly in or on the body (1).

8. A body according to one of claims 1 to 7 **characterised in that** the device (2) is adapted to give off white light.

9. A body according to one of claims 1 to 8 **characterised in that** the device (2) is smaller than 100 µm.

10. A body according to one of claims 1 to 9 **characterised in that** all components of the device (2) are transparent.

11. A body according to claim 1 or claim 10 **characterised in that** the device (2) is embedded in an optical immersion medium whose refractive index is matched to that of the transparent material of the body (1).

## Revendications

1. Corps en verre transparent, qui est facetté au moins par tronçons, avec au moins un dispositif (2) produisant de la lumière, disposé de façon invisible dans ou sur le corps (1), qui présente au moins une puce à semi-conducteur (4) anorganique, un microtrou (9) étant constitué dans le corps (1) pour la réception au moins partielle de la puce à semi-conducteur (4), et au moins la puce à semi-conducteur (4) étant constituée de façon transparente.

2. Corps selon la revendication 1, **caractérisé en ce que** la puce à semi-conducteur (4) est constituée pour l'émission d'un rayonnement électromagnétique dans une plage du spectre visible.

3. Corps selon la revendication 1, **caractérisé en ce que** la puce à semi-conducteur (4) est constituée pour l'émission d'un rayonnement électromagnétique à l'extérieur de la plage visible du spectre.

4. Corps selon la revendication 2 ou 3, **caractérisé en ce que** le dispositif (2) présente un convertisseur de longueur d'onde (6) pour la conversion au moins partielle en lumière d'au moins une partie du rayonnement émis par la puce à semi-conducteur (4).

5. Corps selon l'une des revendications 1 à 4, **caractérisé en ce que** le dispositif (2) présente un miroir (7) au moins partiellement transparent par lequel au moins une partie du rayonnement émis par la puce à semi-conducteur (4) peut être réfléchie dans l'intérieur du corps (1).

6. Corps selon l'une des revendications 1 à 5, **caractérisé en ce que** le microtrou (9) est disposé sur une surface du corps (1).

7. Corps selon l'une des revendications 1 à 6, **caractérisé en ce que** l'alimentation en énergie du dispositif (2) s'effectue par le biais de contacts (10) électriques disposés de façon invisible dans ou sur le corps (1).

8. Corps selon l'une des revendications 1 à 7, **caractérisé en ce que** le dispositif (2) est constitué pour la délivrance de lumière blanche.

9. Corps selon l'une des revendications 1 à 8, **caractérisé en ce que** le dispositif (2) est inférieur à 100 µm.

10. Corps selon l'une des revendications 1 à 9, **caractérisé en ce que** tous les composants du dispositif (2) sont constitués de façon transparente.

11. Corps selon la revendication 1 ou 10, **caractérisé en ce que** le dispositif (2) est noyé dans un fluide d'immersion optique dont l'indice de réfraction est adapté à celui du matériau transparent du corps (1).
